# EUROPEAN PATENT SPECIFICATION

(11) **EP 1 716 452 B1**
(45) Date of publication and mention of the grant of the patent: **10.09.2008**
(21) Application number: 05715334.8
(22) Date of filing: 15.02.2005
(51) Int. Cl.: G03F 7/00

(54) **METHOD FOR PROVIDING A THIN FILM HAVING A CHEMICAL COMPOSITION THAT IS SPATIALLY STRUCTURED ON A MICROMETRIC OR NANOMETRIC SCALE ON A SUBSTRATE**
VERFAHREN ZUR BEREITSTELLUNG EINES DÜNNFILMS MIT EINER RÄUMLICH IN EINEM MIKROMETRISCHEN ODER NANOMETRISCHEN MASSSTAB AUF EINEM SUBSTRAT STRUKTURIERTEN CHEMISCHEN ZUSAMMENSETZUNG
PROCEDE DE FABRICATION D'UNE COUCHE MINCE POSSEDANT UNE COMPOSITION CHIMIQUE STRUCTUREE SPATIALEMENT A L'ECHELLE MICROMETRIQUE OU NANOMETRIQUE SUR UN SUBSTRAT

(30) Priority: 17.02.2004 IT BO20040076
(43) Date of publication of application: 02.11.2006
(73) Proprietor: Scriba Nanotecnologie S.r.l., 40127 Bologna (IT); CONSEJO SUPERIOR DE INVESTIGACIONES CIENTIFICAS (CSIC), 28006 Madrid (ES)
(72) Inventor: CAVALLINI, Massimiliano, I-40038 Vergato (IT); BISCARINI, Fabio, I-40134 Bologna (IT); RUIZ MOLINA, Daniel, C.S.I.C, E-08193 Cerdanyola (ES); GOMEZ SEGURA, Jordi, C.S.I.C., E-08193 Cerdanyola (ES); VECIANA MIRO', Jaume, C.S.I.C., E-08193 Cerdanyola (ES)
(74) Representative: Alagem Modiano, Lara S.
(86) International application number: PCT/EP2005/001494
(87) International publication number: WO 2005/078521

(56) References cited:
- US-A1- 2003 082 485
- US-A1- 2004 013 982
- "PLASMA TREATMENT TO IMPROVE RESIST ADHESION" IBM TECHNICAL DISCLOSURE BULLETIN, IBM CORP. NEW YORK, US, vol. 35, no. 2, 1 July 1992 (1992-07-01), pages 321-322, XP000313315 ISSN: 0018-8689
- DAVID C ET AL: "Nano-structured anti-reflective surfaces replicated by hot embossing" MICROELECTRONIC ENGINEERING, ELSEVIER PUBLISHERS BV., AMSTERDAM, NL, vol. 61-62, July 2002 (2002-07), pages 435-440, XP004360566 ISSN: 0167-9317

## Description

### Technical Field

The present invention relates to a method for providing a thin film on a substrate and particularly to a method for providing a thin film having a chemical composition that is spatially structured on a micrometric or nanometric scale, constituted by patterns and/or structures having micrometric and/or nanometric dimensions.

### Background Art

In the production for example of integrated circuits, optical devices, magnetic devices and the like, one of the best-known and most widely used treatment methods is lithography.

One of the crucial steps in lithography entails depositing on a substrate a thin film and generating thereon a contact mask, so that during subsequent treatments the model of the mask can be transferred onto the substrate by removing the material that constitutes the substrate or by depositing another material.

A typical process of lithography in submicrometric or nanometric treatments, for providing details, consists in depositing a film on a substrate and then exposing the film with the corresponding substrate to a beam of high-energy particles, such as electrons, photons or ions, optionally through a mask that bears a chosen model.

Said beam changes the chemical structure of the exposed region of the film and leaves the unexposed region unchanged.

By immersing the substrate and the film in a developing agent, the region of film exposed to the energy beam, or alternatively the region that is not exposed, is removed, obtaining a film that reproduces the model or the corresponding negative, traced in said mask.

The print resolution that can be obtained in lithographic procedures is limited by the wavelength of the particles used to etch the film, by the properties of the film and by the developing process.

Lithographic methods based on beams of ions or electrons allow high spatial resolution (tens of nanometers), but are serial methods, i.e., the patterns are written one by one.

These techniques are limited by the scanning speed of the particle beam and accordingly are scarcely suitable for large-scale treatments and for mass production.

Parallel methods (i.e., methods that allow to write multiple patterns simultaneously) such as a photolithography are known, but they become extremely expensive when the details to be written have dimensions on the order of 100 nm, due to the costs of the materials and of the optical elements for high-energy radiation such as for example X-rays.

In order to obviate the cited drawbacks, alternative lithographic techniques have been developed which have the requirement of being parallel and at the same time allow to produce details of submicrometric and nanometric size on film in a simple way and at low cost.

An example is disclosed in patent US 5,772,905, which proposes a lithographic method that combines conventional lithographic technologies with the less expensive method, already known with resolutions on the order of a millimeter, of pressure molding (embossing), providing moldings on nanometric or submicrometric scales (nanoembossing or nanoimprinting) of thermoplastic polymers.

This patent describes a low-cost but high-resolution lithographic approach that abandons the use of energy beams or particle beams.

Nanoembossing entails placing an appropriately shaped mold over a polymeric film placed on a rigid substrate and applying pressure, optionally accompanied by suitable heating of said substrate.

The molding generates on the film series of protrusions and recesses that correspond to the respective recesses and protrusions of said mold.

The portions of film at the recesses are then removed, obtaining on the substrate a model of film that mirrors the recesses of the mold; the polymeric film thus molded must then be developed, according to known methods, in order to obtain the intended product.

However, this method is limited by the modeling of the substrate and of the film and/or by the treatment of the silicon, which is a widely used material in these applications.

Nanoembossing, moreover, does not allow to provide directly a spatially controlled distribution of material on the substrate (otherwise known as "chemical attern").

The aim of the present invention is therefore to obviate the cited drawbacks by defining a method for manufacturing patterns having a different chemical nature in thin films directly on a substrate, without having to deposit or model said film but by modeling and subsequent conditioning of the substrate.

Methods for modeling by pressure molding and replication molding are widely known; in the case of pressure molding, a mold is placed in contact with a substrate and is pressed thereon so that the patterns of the mold are reproduced in negative form on the surface of the substrate, while in the replication method, a solution in which the substrate, for example a polymeric substrate, has been dissolved is deposited onto a mold, and once the evaporation of the solvent has ended the polymer solidifies and assumes the shape of the mold.

IBM TECH. DISC. BULL., 01-07-1992, vol. 35, No.2, p321-322, discloses a method for providing a thin film on a substrate silica particles are partially embedded in a PTFE matrix, the film being formed by silica, comprising the steps of dispersing the silica in the substrate to obtain a mixture (silica-filled PTFE sheet), modelling and conditioning the mixture, by plasma treatment, the modelling step comprising the step of forming protrusions and recesses.

### Disclosure of the Invention

The invention provides a method for providing a thin film (2) on a substrate (1) in order to obtain a product (9), said film (2) being formed by a material (3), characterized in that it comprises the steps of:
- dispersing said material (3) in the substrate material in order to obtain a mixture (10);
- modeling said mixture (10);
- conditioning said mixture (10),
said modeling step comprising a step for forming, on a surface (10a) of said mixture (10), protrusions (7) and recesses (6) depending on the intended distribution of the thin film on the surface of the substrate, **characterized in that** said conditioning step comprises a step of causing said material (3) to emerge on said surface with a higher concentration where protrusions (7) are located, said step of causing said material to emerge comprising the step of smoothing said mixture (10) in order to smooth any surface roughness, said surface roughness further comprising said protrusions (7).

The method according to the present invention provides on a substrate a chemically structured thin film having a chemical structure that is spatially controlled at the microscale and/or nanoscale level.

### Brief Description of the Drawings

The technical characteristics of the invention, according to this aim, can be clearly determined from the contents of the appended claims, and its advantages will become better apparent in the following detailed description, given with reference to the accompanying drawings and photographs, which illustrate a merely exemplifying and non-limiting example of embodiment thereof, wherein:
Figures 1a, 1b and 1c are schematic enlarged-scale side views of a sequence of operations for modeling a mixture by pressure molding;
Figures 2a, 2b and 2c are schematic enlarged-scale side views of a sequence of operations for modeling the mixture by replica molding;
Figure 3a is a schematic enlarged-scale side view of the detail B of Figure 1c;
Figures 3b, 3c and 3d are schematic side views of the evolution of the mixture so as to form the spatially structured film with the method according to the present invention;
Figure 4 is a perspective view of an image, taken with an atomic force microscope (AFM), of a replica molded mixture, obtained by using an etched digital video disc (DVD) as a mold;
Figure 5 is a perspective view of an image, taken with an atomic force microscope (AFM), of a replica molded mixture, obtained by using a rewritable DVD as the mold;
Figure 6 is a topographic atomic-force microscope image of a polymeric substrate with an associated film, in an intermediate stage, shown schematically in Figure 3c, of the method according to the present invention;
Figure 7 is a phase-contrast image of the same film as in Figure 6;
Figure 8 is an atomic-force microscope (AFM) topographic image of the polymeric substrate with the associated film in a stage that follows the stage shown in Figure 6;
Figure 9 is a magnetic-force microscope image of the polymeric substrate with the associated film in the stage of Figure 8;
Figure 10 illustrates a sequence of bits of a track of a DVD and a reconstruction of the topographic profile of said sequence, obtained from a track of the substrate of Figure 8;
Figure 11 is a view of the actual topographic profile of the substrate with the associated film, which reproduces the track of Figure 10, obtained with the method according to the present invention;
Figure 12 is a view of the magnetic profile that corresponds to the topographic profile of Figure 11 and of the sequence of bits acquired from the magnetic profile as a function of the fluctuations with respect to the average value;
Figure 13 is a view of another evolution of the film, for longer conditioning times, obtained with the method according to the present invention.

### Modes for carrying out the Invention

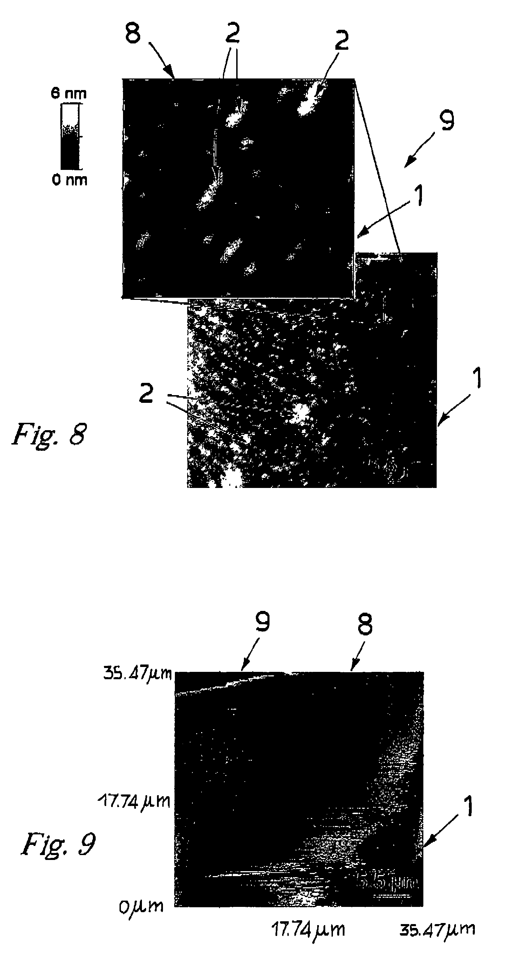

In accordance with the accompanying drawings, and with particular reference to Figure 8, the reference numeral 1 designates the substrate; a film 2, composed of a material 3 that is originally dispersed in said substrate 1 as explained hereinafter, is formed on the surface of said substrate.

In the continuation of the present description, reference will be made, without thereby losing in generality, to a substrate 1 that is constituted by a polymer, particularly polycarbonate, and to a material 3 that is constituted by molecules that contain groups of 12 atoms of manganese and are known in the literature as molecular magnets (hereinafter referenced as SMM); these materials 3 are ferromagnetic at low temperatures and paramagnetic at ambient temperature. Currently, the typical paramagnetic/ferromagnetic transition temperature (known as Curie temperature) for these materials is on the order of 10 K.

These substances are taken as an example to describe the method, but said method can be applied to a wide range of materials 3 and substrates 1, including biological molecules such as for example biopolymers, proteins and the like, and copolymers; likewise, reference will be made to nanometric spatial scales, since this is the field of greatest interest in the application of the described method, which however remains valid and effective also for larger dimensions.

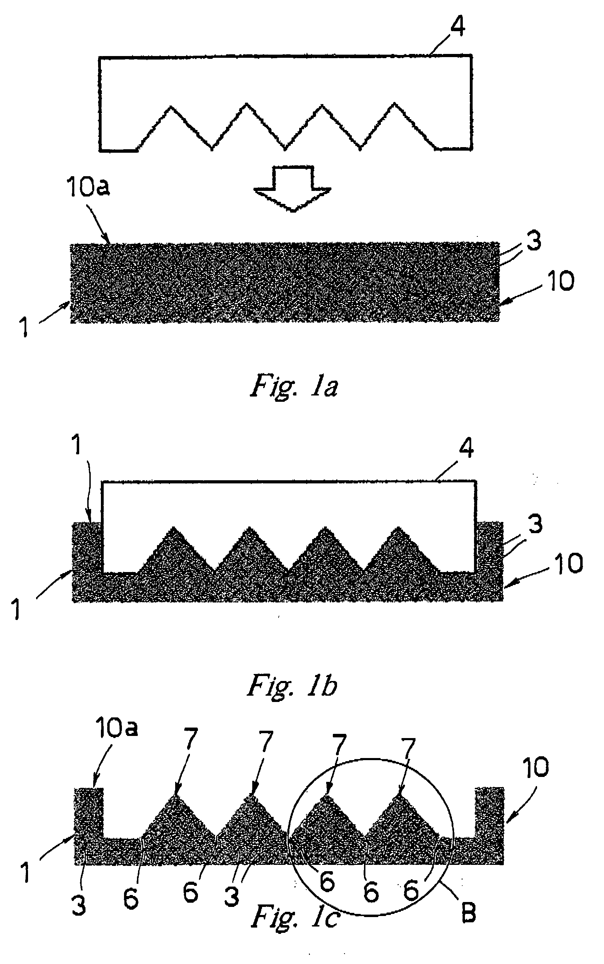

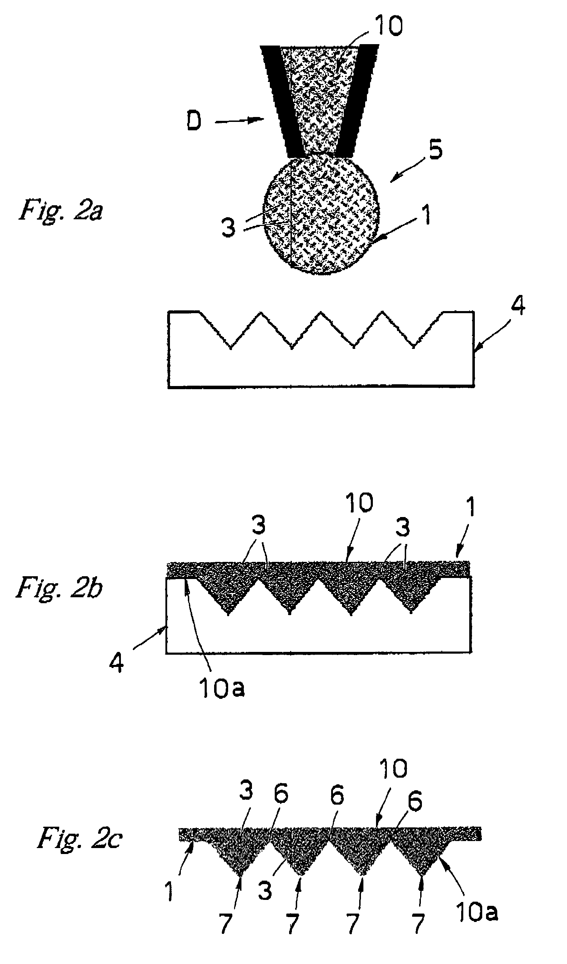

With particular reference to Figures 1a and 2a, the method provides for a preliminary step, in which the material 3 intended to form the film 2 is dispersed uniformly in the substrate 1 in order to form a mixture 10 that accordingly comprises the substrate 1 and the material 3.

Subsequently, a surface 10a of the mixture 10, which coincides with the surface of the substrate 1, is modeled, depending on the intended distribution of the film 2, on the surface of the substrate 1, as explained hereinafter.

According to what is illustrated in Figures 1a, 1b and 1c, the mixture 10 can be modeled by pressure with a mold 4 or, as shown in Figures 2a, 2b, and 2c, replica molded; in both cases, these methods are known in the modeling, for example, of polymers and therefore are described only to the extent needed for comprehension of the text, since they are applied to the mixture 10 as if it were a polymer.

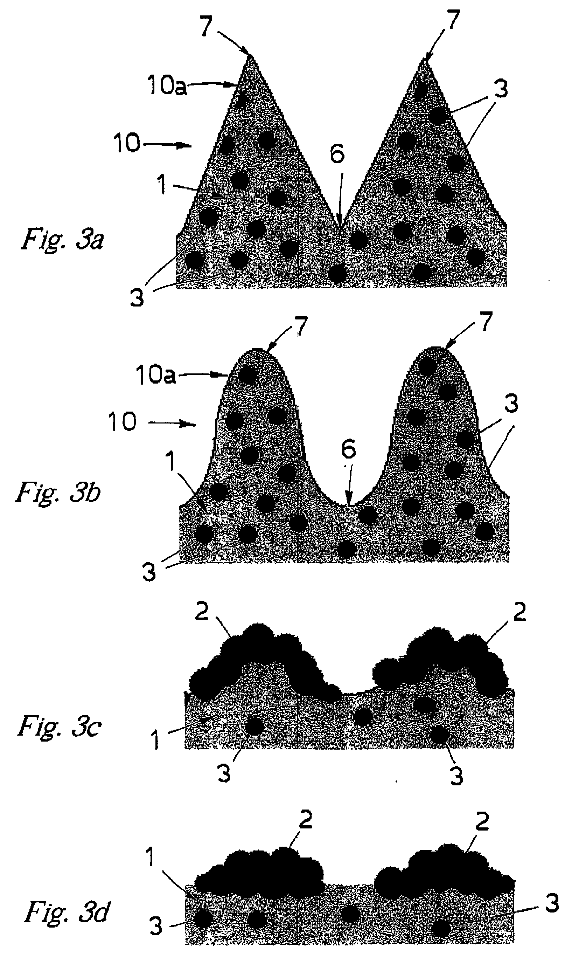

With particular reference to Figures 1a, 1b and 1c, in order to provide pressure molding, a nanostructured mold 4 is placed in contact with the mixture 10 and is pressed onto it in such a manner that the patterns of the mold 4, i.e., the parts in relief, are reproduced in negative form on the surface 10a of the mixture 10; this molding method can be performed after heating the mixture 10 above the characteristic glass transition temperature (Tc) of the polymer that constitutes the substrate 1, so as to make said polymer soft enough and allow to fill the recesses of the mold. Figure 3a illustrates, in a further enlarged scale, the detail B of Figure 1c.

With reference to Figures 2a, 2b and 2c, in the replica molding, a solution 5 in which the mixture 10 has been dissolved is deposited, generally in the liquid state, by means of a distribution device D on a mold 4 that is provided with a model having nanometric dimensions; according to known phenomena, the polymer solidifies and assumes the shape of the mold 4, so that the patterns of the mold 4, i.e., the parts in relief, are reproduced in negative form on the surface 10a of the mixture 10.

Advantageously, the step for modeling the mixture 10 can occur in any way, for example also by means of a simple etching or of any method that produces on the surface 10a recesses or recessed parts 6 and protrusions or relief parts 7.

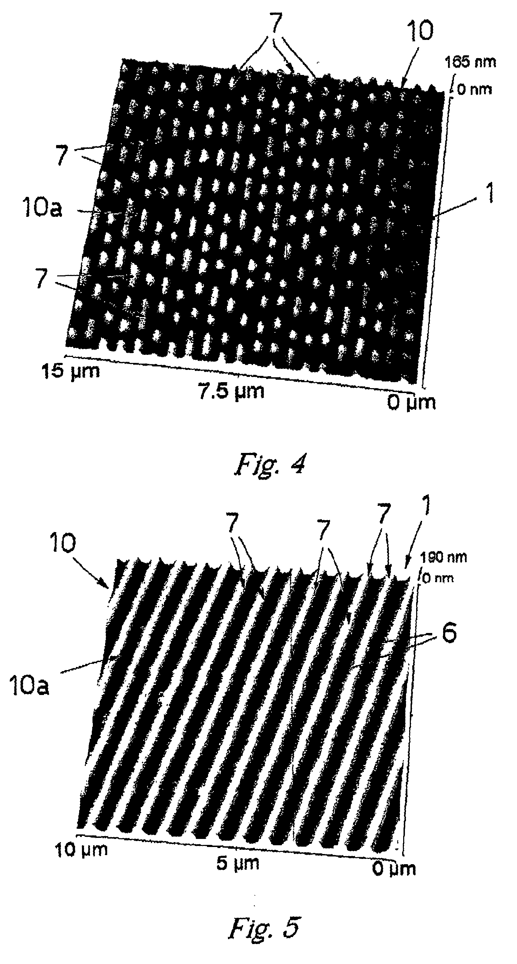

Figures 4 and 5 illustrate respectively an image of a replica molded mixture 10, obtained by using as a mold an etched digital video disc (DVD), and an image of a replica molded mixture 10 by using a recordable DVD as a mold.

In general, in performing the present method, the protrusions 7 on the mixture 10 correspond, as explained hereinafter, to the intended distribution of the film 2, i.e., to the intended concentration of the SMMs in the case described in the example on the surface of the substrate 1.

In particular, therefore, if one wishes to provide on the surface of the substrate 1 a precise distribution of the dispersed material 3, it is necessary to provide the mold 4 so that it produces on the mixture 10 the protrusions 7 that have shapes and dimensions that correspond to the intended distribution of material 3; in order to model the mixture 10 and form the film 2, as shown for example in Figure 8, an etched DVD, as in Figure 4, has been used as a mold.

At the end of the modeling process, the mixture 10 is exposed to a solvent or to solvent vapors, for example, without losing in generality, in the case of polycarbonate and SMM, to dichloromethane; in the case of exposure to the solvent, the substrate 1 preferably is at least partially soluble in a solvent.

According to known phenomena, this exposure induces substantially two effects: the smoothing of the surface 10a of the mixture 10, or the reduction of the roughness of the surface of the substrate 1, and the surfacing of the SMM molecules, i.e., of the dispersed material 3, on said surface, at first in isolation and then, by extending the exposure time, in groups which first form a thin film of SMMs and then form aggregates that are shaped like a closed ring, particularly due to the dewetting of the thin film 2 of material 3 that has emerged from said substrate 1.

With particular reference to Figures 3b, 3c and 3d, it is noted that at the relief parts 7, simultaneously with a rounding thereof, more molecules 3 emerge with respect to the recessed parts 6, and by continuing the exposure to the solvent the aggregation and subsequent evolution of the film 2 on the surface of the substrate 1 is anticipated at the regions 7 that were previously in relief as the surface 10a of the mixture 10 has been molded beforehand.

This localized emergence forms, in the case of polycarbonate and molecular magnets of the example, permanent magnetic memory elements 8, shown in Figures 8, 9 and 12.

These elements 8 are therefore constituted by a polymeric substrate 1 (in which, however, some isolated molecules of material 3 remain dispersed, their presence being negligible and allowing to refer, in this step, simply to the substrate 1 and not to a mixture 10) and by a film 2 constituted by SMMs; in the elements 8, the material 3 having magnetic properties is more concentrated in the regions of the mixture 10 that were previously in relief; the material 3 that is initially dispersed within the polymer 1 emerges on the surface of the substrate 1 thereof following exposure to the solvent and aggregates in the film 2.

The molecules emerge on the entire surface of the polymer but with a different concentration, i.e., a higher concentration where the relief parts 7 were located; moreover, not all the material 3 concentrates on the surface of the substrate 1, but a part remains embedded and dispersed within the polymer, as shown schematically by way of example in Figure 3d.

Consequently, molecule aggregates form in certain regions and evolve, forming continuous films 2, and in the regions that were originally recessed the emerged molecules remain isolated because not enough material 3 emerges to form the films 2 or large aggregates (except for very long exposures to the solvent).

This surface aggregation, obtained in the case shown in example by exposing the mixture 10 to solvent vapors, can also occur by means of a suitable thermal treatment of said mixture 10.

It should be noted that in the case of emergence obtained by exposure to a solvent, the substrate 1 must have suitable surface dissolution characteristics, according to known phenomena.

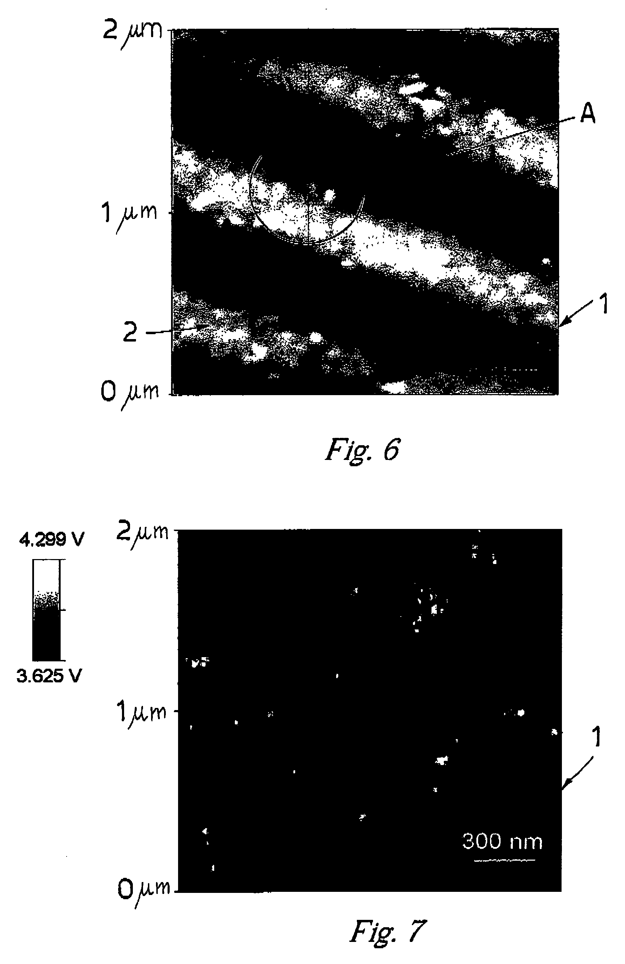

Images of the various steps of aggregation in a modeled specimen are visible in Figures 6, 7, 8, 9 and 13, which refer to a polycarbonate substrate 1 that contains 3% SMMs by weight with respect to the weight of the polymer.

It should be noted that by varying the amount of material 3 dispersed within the substrate 1, the aggregation times of the material 3 on the surface change; these times depend on the nature of the materials used, on the nature of the substrate 1, on the value of the roughness of the modeled substrate 1, and on environmental conditions such as temperature and relative humidity.

Advantageously, these aggregation times might be adjusted by varying the environmental conditions in which the method according to the invention is developed.

In particular, for an equal conditioning time and if the temperature is set, the film 2 might be provided by acting on the ambient humidity, and likewise, if the humidity is fixed, the film 2 might be provided by acting on the ambient temperature.

Figure 6 in particular illustrates a substrate 1 in which the material 3 is dispersed after exposure to the solvent (in the particular case, dichloromethane) for 200 seconds with an ambient temperature of 23°C and an ambient relative humidity of 51%.

Considering the feature A of said image, it can be seen that an aggregation as shown schematically in Figure 3c has occurred.

Figure 7 is an image produced by phase contrast, a method that is known for highlighting the different chemical or physical nature of materials present on a surface of the substrate 1 in the same conditions of Figure 6.

By extending the exposure to the solvent of the substrate 1 and of the material 3 of Figure 6, in particular by exposing it to the solvent for 300 seconds with the same temperature and humidity conditions described earlier, the aggregation state, shown in Figure 8 and also shown schematically in Figure 3d, is reached.

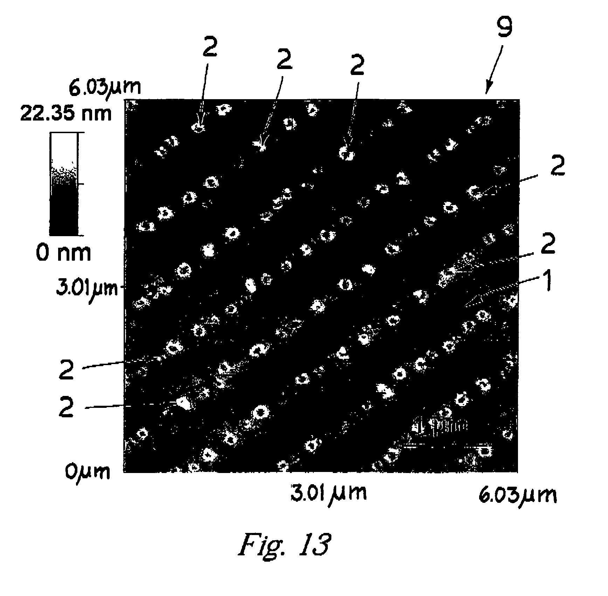

Moreover, it can be noted that by extending the exposure to the solvent up to 400 seconds, the dispersed material 3 aggregates as shown in Figure 13.

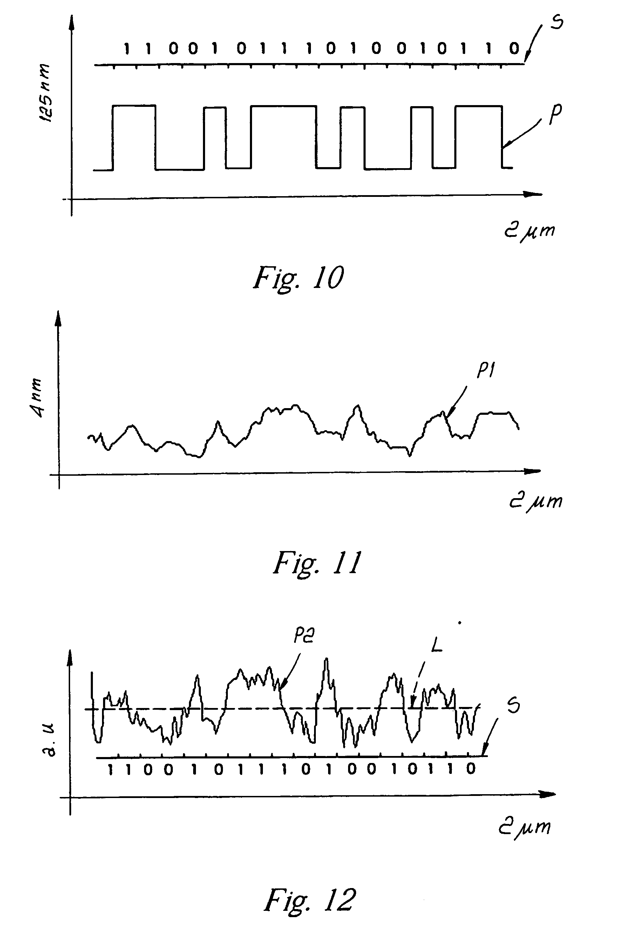

With particular reference to Figure 10, a sequence S of bits of a track of the DVD used to model the mixture 10 as shown in Figure 4 is observed, and so is the reconstruction of the original topographic profile P (i.e., before conditioning) of said track on the mixture 10.

Figure 11 is a view of the actual topographic profile P1 of the substrate 1 and of the corresponding film 2 after exposure to the solvent of the mixture 10 of Figure 4.

Said topographic profile P1 relates to the actual image of Figure 8, i.e., after 300 seconds of exposure, and Figure 12 illustrates its magnetic profile P2, measured with the magnetic-force microscope.

It is noted that if one considers an average line L of the signal, the fluctuations reproduce exactly the same original bit sequence S.

In this way, a film 2 that has the characteristics of the material 3 dispersed in the polymer and is provided with a spacing that corresponds to the protrusions previously provided on the surface 10a of the mixture 10 is substantially formed on the surface of the substrate 1.

By applying the method with different substrates 1 and materials 3, a method for manufacturing numerous products 9 is defined.

In particular, if the material 3 is a conducting material, for example metal, a method is provided for manufacturing conducting wires and electrodes composed of a substrate 1 on which the conducting material 3 is conveniently arranged; if the material 3 has magnetic properties (i.e., is paramagnetic or ferromagnetic), a method is provided for manufacturing magnetically readable memory elements as in the previously described example, said elements being optionally rewritable for particular dispersed materials 3, for example ferromagnetic materials; if the material 3 has optical properties (for example has photoluminescence and/or electroluminescence properties), a method is defined for manufacturing optically readable memory elements which can be rewritable for particular materials 3, such as for example optical switches.

In general, a method is therefore provided for organizing in a spatially controlled manner, on a submicrometric and/or nanometric scale, a material 3 on a substrate 1 so that the properties of the material 3 dispersed originally in the substrate 1 define the characteristics of the product 9 obtained with said method, as a function of the distribution of the film 2 obtained on the surface of said substrate 1.

The spatially controlled distribution of the material 3 on the substrate 1, also termed "chemical pattern", is itself a useful product in various production processes, such as for example a substrate for the differentiated growth of thin films or a step of a manufacturing process; advantageously, said method can also be used with substrates 1 that are organic, inorganic or biological in nature.

This method can also be used with any type of material 3 and substrate 1 in order to obtain, without losing in generality, light emitting diodes, field- effect transistors, diodes and other devices.

In particular, the substrate 1 can be an organic, inorganic or biological substrate and likewise the dispersed material 3 can be an organic or inorganic material; according to further embodiments, the method according to the invention can be used with substrates 1 based on gels or substrates that comprise polymeric mixtures.

If the dispersed material 3 is a semiconductor, it is possible to obtain an electrode or even a film 2 in which the semiconductor is the active element.

The present invention also relates to an electrode, an optically readable and rewritable or non-rewritable memory element, a magnetically readable and rewritable or non-rewritable memory element obtained with the method described above, and to a spatially structured chemical pattern.

Advantageously, once the material 3 has emerged on the surface of the substrate 1, forming the film 2, it can be treated chemically or by physical processes (for example thermal treatments or exposure to ions, photons or others) in order to change its intrinsic properties; moreover, a chemical treatment can also be used to cover said film 2 with a protective layer.

The invention achieves the proposed aim and objects, and in particular the method allows to manufacture directly thin-film patterns on a corresponding substrate without having to resort to lithographic processes.

This method uses in a novel way the emergence of a material dispersed in a substrate, following exposure to a solvent, by making the material concentrate in certain regions following a conditioning of the mixture with said material dispersed therein, before exposing it to said solvent.

Substantially, this method allows to distribute in a controlled manner, with the chosen spatial arrangement, a material that is initially dispersed in a polymer on the surface of said polymer.

The method as described operates on a micrometric and nanometric scale and is fully within the field of nanotechnologies.

It should be noted that a product 9 thus obtained is the result of a kinetic process, not of a thermodynamic process, and has substantially no topography but a precise state of aggregation of the material 3 on the surface of the substrate 1.

The invention thus conceived is susceptible of various industrial applications; it is defined by the appended claims; all the details may further be replaced with technically equivalent elements.

Where technical features mentioned in any claim are followed by reference signs, those reference signs have been included for the sole purpose of increasing the intelligibility of the claims and accordingly such reference signs do not have any limiting effect on the interpretation of each element identified by way of example by such reference signs.

## Claims

1. A method for providing a thin film (2) on a substrate (1) in order to obtain a product (9), said film (2) being formed by a material (3), comprising the steps of:
- dispersing said material (3) in the substrate material in order to obtain a mixture (10);
- modeling said mixture (10);
- conditioning said mixture (10),
said modeling step comprising a step for forming, on a surface (10a) of said mixture (10), protrusions (7) and recesses (6) depending on the intended distribution of the thin film on the surface of the substrate, **characterized in that** said conditioning step comprises a step of causing said material (3) to emerge on said surface with a higher concentration where protrusions (7) are located , said step of causing said material to emerge comprising the step of smoothing said mixture (10) in order to smooth any surface roughness, said surface roughness further comprising said protrusions (7).

2. The method according to claim 1, **characterized in that** said smoothing step comprises a step of exposing said mixture (10) to a solvent.

3. The method according to claim 1, **characterized in that** said smoothing step comprises a step of heating said mixture (10).

4. The method according to any one of the preceding claims 1 to 3, **characterized in that** it comprises a step of treating, chemically and/or by means of any physical treatment, said emerged material (3) in order to modify its intrinsic properties.

5. The method according to claim 4, **characterized in that** said chemical treatment step comprises a step for coating said emerged material (3) with a protective layer.

6. The method according to any one of the preceding claims 1 to 5, **characterized in that** said modeling step comprises a step of etching said mixture (10).

7. The method according to any one of the preceding claims 1 to 6, **characterized in that** said modeling step comprises a step of pressure molding said mixture (10).

8. The method according to any one of claims 6 or 7, **characterized in that** said modeling step comprises a step of heating said mixture (10) in order to soften said substrate (1).

9. The method according to any one of the preceding claims 1 to 5, **characterized in that** said modeling step comprises a step of replica molding said mixture (10).

10. The method according to any one of the preceding claims 1 to 9, **characterized in that** said substrate (1) comprises a polymeric mixture.

11. The method according to any one of the preceding claims 1 to 9, **characterized in that** said substrate (1) comprises a polymer.

12. The method according to claim 11, **characterized in that** said polymer comprises polycarbonate.

13. The method according to any one of the preceding claims 1 to 9, **characterized in that** said substrate (1) comprises a copolymer.

14. The method according to any one of the preceding claims 1 to 9, **characterized in that** said substrate (1) comprises a molecular material.

15. The method according to any one of the preceding claims 1 to 9, **characterized in that** said substrate (1) comprises biological molecules.

16. The method according to any one of the preceding claims 1 to 9, **characterized in that** said substrate (1) comprises a gel.

17. The method according to any one of the preceding claims 1 to 9, **characterized in that** said substrate (1) is an organic material.

18. The method according to any one of the preceding claims 1 to 9, **characterized in that** said material (3) is an organic material.

19. The method according to any one of the preceding claims 1 to 9, **characterized in that** said material (3) is a biological material.

20. The method according to any one of the preceding claims 1 to 9, **characterized in that** said substrate (1) is an inorganic material.

21. The method according to any one of the preceding claims 1 to 9, **characterized in that** said material (3) is an inorganic material.

22. The method according to any one of the preceding claims 1 to 9, **characterized in that** said substrate (1) is soluble in a solvent.

23. The method according to any one of the preceding claims 1 to 9, **characterized in that** said material (3) is a conducting material and the resulting product (9) is an electrode, said film (2) being a conducting film.

24. The method according to claim 23, **characterized in that** said conducting material comprises a metal or metallic particles.

25. The method according to any one of the preceding claims 1 to 9, **characterized in that** said material (3) is a semiconducting material and the resulting product (9) is an electrode.

26. The method according to any one of the preceding claims 1 to 9, **characterized in that** said material (3) is a semiconducting material and the resulting product (9) is an electronic device or photovoltaic cell or light-emitting diode, said film (2) being a semiconducting film.

27. The method according to any one of the preceding claims 1 to 9, **characterized in that** said material (3) is a magnetic material and the resulting product (9) is a magnetically readable memory element.

28. The method according to claim 27, **characterized in that** said magnetically readable memory element is rewritable, said magnetic material being ferromagnetic.

29. The method according to any of the preceding claims 1 to 9, **characterized in that** said material (3) has optical properties and the resulting product (9) is an optically readable memory element.

30. The method according to claim 29, **characterized in that** said optically readable memory element is rewritable.

31. The method according to any of the preceding claims 1 to 30, wherein the parameters of temperature and humidity are fixed, **characterized in that** said production of the film (2) is regulated by acting on the duration of said conditioning step.

32. The method according to any of the preceding claims 1 to 30, wherein the parameters of temperature and time are fixed, **characterized in that** said production of the film (2) is regulated by acting on the humidity parameter in said conditioning step.

33. The method according to any of the preceding claims 1 to 30, wherein the parameters of humidity and time are fixed, **characterized in that** said production of the film (2) is regulated by acting on the temperature parameter in said conditioning step.

34. A spatially structured chemical pattern, **characterized in that** it is obtained according to the method described in any of the preceding claims 1 to 9, said pattern being constituted by said material (3).

35. An electrode, **characterized in that** it is obtained according to the method described in any of the preceding claims 1 to 9, said material (3) being a conducting material.

36. An electrode, **characterized in that** it is obtained according to the method described in any of the preceding claims 1 to 9, said material (3) being a semiconducting material.

37. The electrode according to claim 35, **characterized in that** said conducting material is metallic.

38. A magnetically readable memory element, **characterized in that** it is obtained according to the method described in any of the preceding claims 1 to 9, said material (3) being a magnetic material.

39. A magnetically readable memory element according to claim 38, **characterized in that** it is rewritable, said magnetic material being ferromagnetic.

40. An optically readable memory element, **characterized in that** it is obtained according to the method described in any of the preceding claims to 9, said material (3) having photoluminescence and/or electroluminescence properties.

41. An optically readable memory element according to claim 40,
**characterized in that** it is rewritable.

## Patentansprüche

1. Ein Verfahren zur Bereitstellung einer Dünnschicht (2) auf einem Substrat (1), um ein Produkt (9) zu erhalten, wobei die Schicht (2) aus einem Material (3) gebildet ist, folgende Schritte umfassend:
- Dispersion des Materials (3) im Substrat-Material, um eine Mischung (10) zu erhalten,
- Modellieren der Mischung (10),
- Konditionierung der Mischung (10),
wobei der Modellierungsschritt einen Schritt zum Formen, auf einer Oberfläche (10a) der Mischung (10), von Vorsprüngen (7) und Vertiefungen (6) abhängig von der geplanten Verteilung der Dünnschicht auf der Oberfläche des Substrats umfasst, **dadurch gekennzeichnet, dass** der Konditionierungsschritt einen Schritt umfasst, um zu bewirken, dass das Material (3) auf der Oberfläche mit einer höheren Konzentration dort austritt, wo sich Vorsprünge (7) befinden, wobei der Schritt, um zu bewirken, dass das Material austritt, den Schritt des Glättens der Mischung (10) umfasst, um eventuelle Oberflächenrauheiten zu glätten, wobei die Oberflächenrauheiten weiter die Vorsprünge (7) umfassen.

2. Das Verfahren gemäß Anspruch 1, **dadurch gekennzeichnet, dass** der Glättungsschritt einen Schritt des Aussetzens der Mischung (10) gegenüber einem Lösungsmittel umfasst.

3. Das Verfahren gemäß Anspruch 1, **dadurch gekennzeichnet, dass** der Glättungsschritt einen Schritt des Erhitzens der Mischung (10) umfasst.

4. Das Verfahren gemäß einem beliebigen der obigen Ansprüche 1 bis 3, **dadurch gekennzeichnet, dass** es einen Schritt des Behandelns, chemisch und/oder durch eine beliebige physikalische Behandlung, des ausgetretenen Materials (3) zur Abänderung seiner innewohnenden Eigenschaften umfasst.

5. Das Verfahren gemäß Anspruch 4, **dadurch gekennzeichnet, dass** der Schritt der chemischen Behandlung einen Schritt der Beschichtung des ausgetretenen Materials (3) mit einer Schutzschicht umfasst.

6. Das Verfahren gemäß einem beliebigen der obigen Ansprüche 1 bis 5, **dadurch gekennzeichnet, dass** der Modellierungsschritt einen Schritt des Ätzens der Mischung (10) umfasst.

7. Das Verfahren gemäß einem beliebigen der obigen Ansprüche 1 bis 6, **dadurch gekennzeichnet, dass** der Modellierungsschritt einen Schritt des Druckpressens der Mischung (10) umfasst.

8. Das Verfahren gemäß einem beliebigen der Ansprüche 6 oder 7, **dadurch gekennzeichnet, dass** der Modellierungsschritt einen Schritt des Erhitzens der Mischung (10), um das Substrat (1) zu erweichen, umfasst.

9. Das Verfahren gemäß einem beliebigen der obigen Ansprüche 1 bis 5, **dadurch gekennzeichnet, dass** der Modellierungsschritt einen Schritt des Abdruckformens der Mischung (10) umfasst.

10. Das Verfahren gemäß einem beliebigen der obigen Ansprüche 1 bis 9, **dadurch gekennzeichnet, dass** das Substrat (1) eine Polymermischung umfasst.

11. Das Verfahren gemäß einem beliebigen der obigen Ansprüche 1 bis 9, **dadurch gekennzeichnet, dass** das Substrat (1) ein Polymer umfasst.

12. Das Verfahren gemäß Anspruch 11, **dadurch gekennzeichnet, dass** das Polymer Polycarbonat umfasst.

13. Das Verfahren gemäß einem beliebigen der obigen Ansprüche 1 bis 9, **dadurch gekennzeichnet, dass** das Substrat (1) ein Copolymer umfasst.

14. Das Verfahren gemäß einem beliebigen der obigen Ansprüche 1 bis 9, **dadurch gekennzeichnet, dass** das Substrat (1) ein Molekularmaterial umfasst.

15. Das Verfahren gemäß einem beliebigen der obigen Ansprüche 1 bis 9, **dadurch gekennzeichnet, dass** das Substrat (1) Biomoleküle umfasst.

16. Das Verfahren gemäß einem beliebigen der obigen Ansprüche 1 bis 9, **dadurch gekennzeichnet, dass** das Substrat (1) ein Gel umfasst.

17. Das Verfahren gemäß einem beliebigen der obigen Ansprüche 1 bis 9, **dadurch gekennzeichnet, dass** das Substrat (1) ein organisches Material ist.

18. Das Verfahren gemäß einem beliebigen der obigen Ansprüche 1 bis 9, **dadurch gekennzeichnet, dass** das Material (3) ein organisches Material ist.

19. Das Verfahren gemäß einem beliebigen der obigen Ansprüche 1 bis 9, **dadurch gekennzeichnet, dass** das Material (3) ein biologisches Material ist.

20. Das Verfahren gemäß einem beliebigen der obigen Ansprüche 1 bis 9, **dadurch gekennzeichnet, dass** das Substrat (1) ein anorganisches Material ist.

21. Das Verfahren gemäß einem beliebigen der obigen Ansprüche 1 bis 9, **dadurch gekennzeichnet, dass** das Material (3) ein anorganisches Material ist.

22. Das Verfahren gemäß einem beliebigen der obigen Ansprüche 1 bis 9, **dadurch gekennzeichnet, dass** das Substrat (1) in einem Lösungsmittel löslich ist.

23. Das Verfahren gemäß einem beliebigen der obigen Ansprüche 1 bis 9, **dadurch gekennzeichnet, dass** das Material (3) ein leitendes Material ist und das resultierende Produkt (9) eine Elektrode ist, wobei die Schicht (2) eine Leitschicht ist.

24. Das Verfahren gemäß Anspruch 23, **dadurch gekennzeichnet, dass** das leitende Material ein Metall oder Metallpartikel umfasst.

25. das Verfahren gemäß einem beliebigen der obigen Ansprüche 1 bis 9, **dadurch gekennzeichnet, dass** das Material (3) ein Halbleitermaterial ist und das resultierende Produkt (9) eine Elektrode ist.

26. Das Verfahren gemäß einem beliebigen der obigen Ansprüche 1 bis 9, **dadurch gekennzeichnet, dass** das Material (3) ein Halbleitermaterial ist und das resultierende Produkt (9) eine elektronische Vorrichtung oder Fotozelle oder Leuchtdiode ist, wobei die Schicht (2) eine Halbleiterschicht ist.

27. das Verfahren gemäß einem beliebigen der obigen Ansprüche 1 bis 9, **dadurch gekennzeichnet, dass** das Material (3) ein magnetisches Material ist und das resultierende Produkt (9) ein magnetisch lesbares Speicherelement ist.

28. Das Verfahren gemäß Anspruch 27, **dadurch gekennzeichnet, dass** das magnetisch lesbare Speicherelement wieder beschreibbar ist und das magnetische Material ferromagnetisch ist.

29. Das Verfahren gemäß einem beliebigen der obigen Ansprüche 1 bis 9, **dadurch gekennzeichnet, dass** das Material (3) optische Eigenschaften hat und dass das resultierende Produkt (9) ein optisch lesbares Speicherelement ist.

30. Das Verfahren gemäß Anspruch 29, **dadurch gekennzeichnet, dass** das optisch lesbare Speicherelement wieder beschreibbar ist.

31. Das Verfahren gemäß einem beliebigen der obigen Ansprüche 1 bis 30, worin die Parameter von Temperatur und Feuchtigkeit festgelegt sind, **dadurch gekennzeichnet, dass** die Herstellung der Schicht (2) durch Einwirken auf die Dauer des Konditionierungsschritts reguliert wird.

32. Das Verfahren gemäß einem beliebigen der obigen Ansprüche 1 bis 30, worin die Parameter von Temperatur und Zeit festgelegt sind, **dadurch gekennzeichnet, dass** die Herstellung der Schicht (2) durch Einwirken auf den Feuchtigkeitsparameter in dem Konditionierungsschritt reguliert wird.

33. Das Verfahren gemäß einem beliebigen der obigen Ansprüche 1 bis 30, worin die Parameter von Feuchtigkeit und Zeit festgelegt sind, **dadurch gekennzeichnet, dass** die Herstellung der Schicht (2) durch Einwirken auf den Temperaturparameter in dem Konditionierungsschritt reguliert wird.

34. Ein räumlich strukturiertes chemisches Muster, **dadurch gekennzeichnet, dass** es gemäß dem Verfahren gewonnen wird, das in einem beliebigen der obigen Ansprüche 1 bis 9 beschrieben ist, wobei das Muster aus dem Material (3) besteht.

35. Eine Elektrode, **dadurch gekennzeichnet, dass** sie gemäß dem Verfahren hergestellt wird, das in einem beliebigen der obigen Ansprüche 1 bis 9 beschrieben ist, wobei das Material (3) ein leitendes Material ist.

36. Eine Elektrode, **dadurch gekennzeichnet, dass** sie gemäß dem Verfahren hergestellt wird, das in einem beliebigen der obigen Ansprüche 1 bis 9 beschrieben ist, wobei das Material (3) ein Halbleitermaterial ist.

37. Die Elektrode gemäß Anspruch 35, **dadurch gekennzeichnet, dass** das leitende Material metallisch ist.

38. Ein magnetisch lesbares Speicherelement, **dadurch gekennzeichnet, dass** es gemäß dem Verfahren hergestellt wird, das in einem beliebigen der obigen Ansprüche 1 bis 9 beschrieben ist, wobei das Material (3) ein magnetisches Material ist.

39. Das magnetisch lesbares Speicherelement gemäß Anspruch 38, **dadurch gekennzeichnet, dass** es wieder beschreibbar ist, wobei das magnetische Material ferromagnetisch ist.

40. Ein Optisch lesbares Speicherelement, **dadurch gekennzeichnet, dass** es gemäß dem Verfahren hergestellt wird, das in einem beliebigen der obigen Ansprüche 1 bis 9 beschrieben ist, wobei das Material (3) Fotolumineszenz- und/oder Elektrolumineszenz-Eigenschaften hat.

41. Das Optisch lesbares Speicherelement gemäß Anspruch 40, **dadurch gekennzeichnet, dass** es wieder beschreibbar ist.

## Revendications

1. Un procédé de fourniture d'un film mince (2) sur un substrat (1) afin d'obtenir un produit (9), ledit film (2) étant formé par un matériau (3), comprenant les étapes consistant à :
- disperser ledit matériau (3) dans le matériau de substrat afin d'obtenir un mélange (10) ;
- modeler ledit mélange (10) ;
- conditionner ledit mélange (10),
ladite étape de modelage comprenant une étape de formation, sur une surface (10a) dudit mélange (10), de saillies (7) et de creux (6) en fonction de la répartition souhaitée du film mince sur la surface du substrat, **caractérisé en ce que** ladite étape de conditionnement comprend une étape consistant à faire en sorte que ledit matériau (3) émerge sur ladite surface avec une plus forte concentration à l'endroit où sont situées les saillies (7), ladite étape consistant à faire en sorte que ledit matériau émerge comprenant l'étape de lissage dudit mélange (10) afin de lisser toute rugosité de surface, ladite rugosité de surface comprenant en outre lesdites saillies (7).

2. Procédé selon la revendication 1, **caractérisé en ce que** ladite étape de lissage comprend une étape consistant à exposer ledit mélange (10) à un solvant.

3. Procédé selon la revendication 1, **caractérisé en ce que** ladite étape de lissage comprend une étape consistant à chauffer ledit mélange (10).

4. Procédé selon l'une quelconque des revendications précédentes 1 à 3, **caractérisé en ce qu'**il comprend une étape consistant à traiter, de manière chimique et/ou au moyen de tout traitement physique, ledit matériau émergé (3) afin de modifier ses propriétés intrinsèques.

5. Procédé selon la revendication 4, **caractérisé en ce que** ladite étape de traitement chimique comprend une étape consistant à recouvrir ledit matériau émergé (3) d'une couche de protection.

6. Procédé selon l'une quelconque des revendications précédentes 1 à 5, **caractérisé en ce que** ladite étape de modelage comprend une étape consistant à graver ledit mélange (10).

7. Procédé selon l'une quelconque des revendications précédentes 1 à 6, **caractérisé en ce que** ladite étape de modelage comprend une étape de moulage par pression dudit mélange (10).

8. Procédé selon l'une quelconque des revendications précédentes 6 ou 7, **caractérisé en ce que** ladite étape de modelage comprend une étape consistant à chauffer ledit mélange (10) afin de ramollir ledit substrat (1).

9. Procédé selon l'une quelconque des revendications précédentes 1 à 5, **caractérisé en ce que** ladite étape de modelage comprend une étape de réplication par moulage dudit mélange (10).

10. Procédé selon l'une quelconque des revendications précédentes 1 à 9, **caractérisé en ce que** ledit substrat (1) comprend un mélange polymère.

11. Procédé selon l'une quelconque des revendications précédentes 1 à 9, **caractérisé en ce que** ledit substrat (1) comprend un polymère.

12. Procédé selon la revendication 11, **caractérisé en ce que** ledit polymère comprend du polycarbonate.

13. Procédé selon l'une quelconque des revendications précédentes 1 à 9, **caractérisé en ce que** ledit substrat (1) comprend un copolymère.

14. Procédé selon l'une quelconque des revendications précédentes 1 à 9, **caractérisé en ce que** ledit substrat (1) comprend un matériau moléculaire.

15. Procédé selon l'une quelconque des revendications précédentes 1 à 9, **caractérisé en ce que** ledit substrat (1) comprend des molécules biologiques.

16. Procédé selon l'une quelconque des revendications précédentes 1 à 9, **caractérisé en ce que** ledit substrat (1) comprend un gel.

17. Procédé selon l'une quelconque des revendications précédentes 1 à 9, **caractérisé en ce que** ledit substrat (1) est un matériau organique.

18. Procédé selon l'une quelconque des revendications précédentes 1 à 9, **caractérisé en ce que** ledit matériau (3) est un matériau organique.

19. Procédé selon l'une quelconque des revendications précédentes 1 à 9, **caractérisé en ce que** ledit matériau (3) est un matériau biologique.

20. Procédé selon l'une quelconque des revendications précédentes 1 à 9, **caractérisé en ce que** ledit substrat (1) est un matériau inorganique.

21. Procédé selon l'une quelconque des revendications précédentes 1 à 9, **caractérisé en ce que** ledit matériau (3) est un matériau inorganique.

22. Procédé selon l'une quelconque des revendications précédentes 1 à 9, **caractérisé en ce que** ledit substrat (1) est soluble dans un solvant.

23. Procédé selon l'une quelconque des revendications précédentes 1 à 9, **caractérisé en ce que** ledit matériau (3) est un matériau conducteur et **en ce que** le produit en résultant (9) est une électrode, ledit film (2) étant un film conducteur.

24. Procédé selon la revendication 23, **caractérisé en ce que** ledit matériau conducteur comprend un métal ou des particules métalliques.

25. Procédé selon l'une quelconque des revendications précédentes 1 à 9, **caractérisé en ce que** ledit matériau (3) est un matériau semi-conducteur et **en ce que** le produit en résultant (9) est une électrode.

26. Procédé selon l'une quelconque des revendications précédentes 1 à 9, **caractérisé en ce que** ledit matériau (3) est un matériau semi-conducteur et **en ce que** le produit en résultant (9) est un dispositif électronique ou une cellule photovoltaïque ou une diode électroluminescente, ledit film (2) étant un film semi-conducteur.

27. Procédé selon l'une quelconque des revendications précédentes 1 à 9, **caractérisé en ce que** ledit matériau (3) est un matériau magnétique et **en ce que** le produit en résultant (9) est un élément de mémoire à lecture magnétique.

28. Procédé selon la revendication 27, **caractérisé en ce que** ledit élément de mémoire à lecture magnétique est réinscriptible, ledit matériau magnétique étant ferromagnétique.

29. Procédé selon l'une quelconque des revendications précédentes 1 à 9, **caractérisé en ce que** ledit matériau (3) a des propriétés optiques et **en ce que** le produit en résultant (9) est un élément de mémoire à lecture optique.

30. Procédé selon la revendication 29, **caractérisé en ce que** ledit élément de mémoire à lecture optique est réinscriptible.

31. Procédé selon l'une quelconque des revendications précédentes 1 à 30, dans lequel les paramètres de température et d'humidité sont fixes, **caractérisé en ce que** ladite production du film (2) est régulée en agissant sur la durée de ladite étape de conditionnement.

32. Procédé selon l'une quelconque des revendications précédentes 1 à 30, dans lequel les paramètres de température et de temps sont fixes, **caractérisé en ce que** ladite production du film (2) est régulée en agissant sur le paramètre d'humidité dans ladite étape de conditionnement.

33. Procédé selon l'une quelconque des revendications précédentes 1 à 30, dans lequel les paramètres d'humidité et de temps sont fixes, **caractérisé en ce que** ladite production du film (2) est régulée en agissant sur le paramètre de température dans ladite étape de conditionnement.

34. Un motif chimique structuré spatialement, **caractérisé en ce qu'**il est obtenu selon le procédé décrit dans l'une quelconque des revendications précédentes 1 à 9, ledit motif étant constitué par ledit matériau (3).

35. Une électrode, **caractérisée en ce qu'**elle est obtenue selon le procédé décrit dans l'une quelconque des revendications précédentes 1 à 9, ledit matériau (3) étant un matériau conducteur.

36. Une électrode, **caractérisée en ce qu'**elle est obtenue selon le procédé décrit dans l'une quelconque des revendications précédentes 1 à 9, ledit matériau (3) étant un matériau semi-conducteur.

37. Electrode selon la revendication 35, **caractérisée en ce que** ledit matériau conducteur est métallique.

38. Un élément de mémoire à lecture magnétique, **caractérisé en ce qu'**il est obtenu selon le procédé décrit dans l'une quelconque des revendications précédentes 1 à 9, ledit matériau (3) étant un matériau magnétique.

39. Elément de mémoire à lecture magnétique selon la revendication 38, **caractérisé en ce qu'**il est réinscriptible, ledit matériau magnétique étant ferromagnétique.

40. Un élément de mémoire à lecture optique, **caractérisé en ce qu'**il est obtenu selon le procédé décrit dans l'une quelconque des revendications précédentes 1 à 9, ledit matériau (3) ayant des propriétés de photoluminescence et/ou d'électroluminescence.

41. Elément de mémoire à lecture optique selon la revendication 40, **caractérisé en ce qu'**il est réinscriptible.
